# EUROPEAN PATENT APPLICATION

(11) **EP 2 369 632 A2**
(43) Date of publication of application: **28.09.2011**
(21) Application number: 11159501.3
(22) Date of filing: 24.03.2011
(51) Int. Cl.: H01L 31/0384

(54) **Photoelectric conversion device and solar cell**

(30) Priority: 25.03.2010 JP 2010069325
(71) Applicant: Fujifilm Corporation, Minato-ku Tokyo (JP)
(72) Inventor: Shirata, Masashi, Kanagawa-ken (JP)
(74) Representative: Klunker . Schmitt-Nilson . Hirsch

(57) **Abstract**

In order to achieve high photoelectric conversion efficiency in a photoelectric conversion device which can be produced at low cost, the photoelectric conversion device includes: a photoelectric conversion layer (10) containing a semiconductor and having a first surface (10s) as a light absorption surface and a second surface (10r) opposite to the first surface; a first electrode (30) formed substantially in contact with the first surface; and a second electrode (40) formed substantially in contact with the second surface. The photoelectric conversion layer is a monograin film of semiconductor grains (11) which are monograin film of separate semiconductor grains which are arranged substantially in a single layer and each of which is at least partially buried in a binder layer (12), the semiconductor grains have a photoelectric conversion property and an average diameter in the range from one to 60 micrometers, and each of at least part of the semiconductor grains contains at least one stacking fault (13).

## Description

### BACKGROUND OF THE INVENTION

### Field of the Invention

The present invention relates to a photoelectric conversion device and a solar cell which use a photoelectric conversion layer.

### Description of the Related Art

Currently, photoelectric conversion devices having a laminated structure formed of a lower (underside) electrode, a photoelectric semiconductor layer, and an upper electrode are used in various applications including solar cells, where the photoelectric semiconductor layer generates electric current when the photoelectric semiconductor layer absorbs light.

Conventionally, the Si-based solar cells using bulk monocrystalline Si, bulk polycrystalline Si, or thin-film amorphous Si have been the mainstream of the solar cells. On the other hand, research and development of semiconductor compound-based solar cells not using silicon are proceeding. The currently known semiconductor compound-based solar cells include the bulk type solar cells such as the GaAs-based solar cells and the thin-film type solar cells such as the CIS (Cu-In-Se)-based or CIGS (Cu-In-Ga-Se)-based solar cells. The CIS-based or CIGS-based solar cells use semiconductor compounds composed of one or more Group Ib elements, one or more Group IIIb elements, and one or more Group VIb elements, and are reported to exhibit high optical absorptance and high energy conversion efficiency. In this specification, the numbering of the groups of elements are in accordance with the short-period form of the periodic table.

The three-stage process, the selenization process, and the like are known as techniques for producing a CIGS layer. However, according to the above known processes, the CIGS layer is formed in a vacuum. Therefore, the above known processes cost much and require large-scale equipment.

A technique for producing a CIGS layer through a non-vacuum process at low cost has been proposed. According to the proposed technique, a CIGS layer is formed by putting particles containing Cu, In, Ga, and Se on a surface. For example, according to the techniques proposed by S. Ahn et al., "Nanoparticle derived Cu (In, Ga)Se2 absorber layer for thin film solar cells", Colloids and Surfaces A: Physicochemical and Engineering Aspects, Vols. 313-314, pp. 171-174 and S. Ahn et al., "Effects of heat treatments on the properties of Cu(In,Ga)Se2 nanoparticles", Solar Energy Materials and Solar Cells, Vol. 91, Issue 19, pp. 1836-1841, 2007 globular CIGS particles are put on a substrate surface, and are then sintered at the high temperature of approximately 500°C so as to crystallize the CIGS particles which are put on the substrate. In the above literatures, reduction of the heating time by the rapid thermal process (RTP) is considered.

Further, according to the techniques proposed by U.S. Patent Application Publication No. 20050183768, M. Kaelin et al.," "CIS and CIGS layers from selenized nanoparticle precursors", Thin Solid Films, Vols. 431-432, pp. 58-62, 2003 and V.K. Kapur et al., "Non-vacuum processing of CuIn1-xGaxSe2 solar cells on rigid and flexible substrates using nanoparticle precursor inks", Thin Solid Films, Vol. 431-432, pp. 53-57, 2003 , one or more types of globular particles of an oxide or alloy containing Cu, In, and Ga are put on a substrate surface, and then undergo high-temperature heat treatment at the temperature of approximately 500°C in an atmosphere containing Se gas so as to selenize and crystallize the particles which are put on the substrate surface.

However, each of the above techniques require high-temperature heat treatment at the temperature of approximately 500°C, and the cost of the equipment for the high-temperature processes is high. For example, in the case of a continuous process (roll-to-roll process) using a continuous beltlike flexible substrate, the heat treatment takes at least approximately five minutes even when the rapid thermal process (RTP) as disclosed in the Ahn references is used. In consideration of the conveying speeds in the usual roll-to-roll processes for semiconductor devices, the heat treatment time of approximately five minutes is extremely long, so that the sintering furnace is required to have an unrealistically great length. Therefore, it is desirable that the CIGS layers can be formed at as low temperature as possible.

Furthermore, M. Altosaar et al., "Monograin layer solar cells", Thin Solid Films, Vols. 431-432, pp. 466-469, 2003, M. Altosaar et al., "Further developments in CIS monograin layer solar cells technology", Solar Energy Materials and Solar Cells, Vol. 87, Issues 1-4, pp. 25-32, 2005, M. Kauk et al., "The performance of CuInSe2 monograin layer solar cells with variable indium content", Thin Solid,Films, Vol. 515, pp. 5880-5883, 2007, M. Altosaar and E. Mellikov, "CuInSe2 Monograin Growth in CuSe-Se Liquid Phase" in Proceedings of the 12th International Conference Ternary and Multinary Compounds, R.O.C., 2000, Japanese Journal of Applied Physics, Vol. 39, Supplement 39-1, pp. 65-66, 2000, and U.S. Patent No. 6,488,770 and U.S. Patent Application Publication No. 20070189956 disclose monograin layers of CIGS grains. Such CIGS layers do not need high-temperature heat treatment after the CIGS particles are put on surfaces for film formation.

However, since the density of the grains in the monograin CIGS layers is low, sufficient photoelectric-conversion efficiency has not yet been achieved. The Kauk reference reports achievement of the conversion efficiency of 9.5% in the entire light receiving areas excluding electrodes and the like. Nevertheless, the value reported in the Kauk reference is equivalent to the normally defined photoelectric conversion efficiency of 5.7%, which is lower than half of the photoelectric conversion efficiency of the CIGS layers formed in a vacuum, and is not practicable.

### SUMMARY OF THE INVENTION

The present invention has been developed in view of the above circumstances.

The first object of the present invention is to provide a photoelectric conversion device which includes a monograin-layer type photoelectric conversion layer and exhibits superior photoelectric conversion efficiency.

The second object of the present invention is to provide a solar cell having a photoelectric conversion device which includes a monograin-layer type photoelectric conversion layer and exhibits superior photoelectric conversion efficiency.

In order to accomplish the first object, according to the first aspect of the present invention, there is provided a photoelectric conversion device. The photoelectric conversion device comprises: a photoelectric conversion layer containing a semiconductor and having a first surface as a light absorption surface and a second surface opposite to the first surface; a first electrode formed substantially in contact with the first surface; and a second electrode formed substantially in contact with the second surface. The photoelectric conversion layer is a monograin film of separate semiconductor grains which are arranged substantially in a single layer and each of which is at least partially buried in a binder layer, the semiconductor grains have a photoelectric conversion property and an average diameter in the range from one micrometer to 60 micrometers, and each of at least part of the semiconductor grains contains at least one stacking fault.

In the above photoelectric conversion device according to the first aspect of the present invention, the semiconductor grains are substantially separately arranged, and the monograin film is a film in which substantially separate grains are arranged in a plane parallel to a surface of the film in such a manner that basically only one grain exists along the direction perpendicular to the surface of the film. However, in the photoelectric conversion device according to the first aspect of the present invention, at most approximately 10% of the semiconductor grains may be located above or below another semiconductor grain, for example, in the case where some of the semiconductor grains split into a plurality of grains during the film formation process, or relatively flat ones of the semiconductor grains are stacked in the direction perpendicular to the surface of the film.

In this specification, the stacking fault is a planar lattice defect produced by disturbance in the order of stacking atomic planes in a crystal, and corresponds to, for example, a twin plane or a phase boundary. Detailed explanations on the stacking fault are provided in B. Henderson, "Defects in Crystalline Solids", Arnold, London, Chapters 1 and 7, 1972.

Although each of the at least part of the semiconductor grains contains at least one stacking fault, the number of stacking faults contained in each of the at least part of the semiconductor grains is preferably three or more, and more preferably five or more. Preferably, each stacking fault contained in each of the at least part of the semiconductor grains extends to part of the semiconductor grain. Preferably, the proportion of the semiconductor grains containing at least one stacking fault among all the semiconductor grains in the photoelectric conversion layer is preferably 5% or more, more preferably 10% or more, and further preferably 40% or more.

The quantity of the stacking faults can be determined by observing the photoelectric conversion layer by a transmission electron microscope (TEM) or a scanning electron microscope (SEM). Specifically, a specimen for the observation is prepared by fixing on a slide glass the photoelectric conversion layer or the semiconductor grains in which the quantity of the stacking faults is to be determined, and performing carbon evaporation and platinum coating on the photoelectric conversion layer or the semiconductor grains in order to give conductivity to the specimen surface. Then, the specimen is observed by use of a scanning electron microscope with the acceleration voltage of 2 kV for determining the presence or absence of the stacking fault. (For example, the scanning electron microscope is FEI Nova 200 Dual-Beam SEM/FIB, available from FEI Company.)

In order to fix the semiconductor grains on the slide glass, an adhesive is dropped onto the slide glass, and the semiconductor grains are scattered over the adhesive on the slide glass. For example, the above observation is performed on a hundred of semiconductor grains for determining whether or not each of the semiconductor grains contains a streak. When a streak is observed in 10% or more of the semiconductor grains, it is determined that 10% or more of the semiconductor grains contains a stacking fault structure.

In the case where the observation is performed by use of the transmission electron microscope, transmission of electrons through a specimen is essential. Therefore, the photoelectric conversion layer is cut into slices having a thickness from 0.1 nanometers to 100 nanometers for observation.

Further, sections each having a thickness of approximately 100 nanometers are cut out from the position in each semiconductor grain in which a stacking fault is found, and are then observed by use of a transmission electron microscope with the acceleration voltage of 200 kV. (For example, the transmission electron microscope is the transmission electron microscope HF-2200, which is available from Hitachi High-Technologies Corporation.) When a stacking fault exists in a section, a streak is observed. When no stacking fault exists in a section, no structure is observed, and only a smooth surface is observed. Therefore, semiconductor grains in which a streak is observed are determined to contain a stacking fault.

The number of stacking faults existing in each semiconductor grain is determined by counting the number of stacking faults in the sections cut out from the semiconductor grain.

Preferably, the photoelectric conversion device according to the first aspect of the present invention further have one or any possible combination of the following additional features (i) to (iii).
(i) In the photoelectric conversion device according to the first aspect of the present invention, preferably, the semiconductor grains contain as a main component at least one semiconductor compound having a chalcopyrite structure. In this specification, the term "main component" means a component the content of which is 80 mol % or higher.
(ii) In the photoelectric conversion device having the feature (i), preferably, the semiconductor grains contain as at least one main component at least one semiconductor compound composed of at least one Group Ib element, at least one Group IIIb element, and at least one Group VIb element. Hereinafter, the semiconductor compound composed of at least one Group Ib element, at least one Group IIIb element, and at least one Group VIb element may be referred to as the Group I-III-VI semiconductor.
(iii) In the photoelectric conversion device having the feature (ii), preferably, the at least one Group Ib element is at least one of copper (Cu) and silver (Ag), the at least one Group IIIb element is at least one of aluminum (Al), gallium (Ga), and indium (In), and the at least one Group VIb element is at least one of sulfur (S), selenium (Se), and tellurium (Te).

Furthermore, in order to accomplish the aforementioned second object, according to the second aspect of the present invention, a solar cell comprising the photoelectric conversion device according to the first aspect of the present invention is provided.

In the photoelectric conversion device according to the first aspect of the present invention, the stacking faults suppress carrier recombination in the semiconductor grains, so that the carrier lifetime is increased. Therefore, the present invention realizes a photoelectric conversion device exhibiting superior photoelectric conversion efficiency, and a solar cell which includes a photoelectric conversion device exhibiting superior photoelectric conversion efficiency.

Japanese Unexamined Patent Publication No. 2009-32966 (JP2009-032966) discloses that a semiconductor layer in a light emitting diode having a layered semiconductor structure contains a crystal defect (stacking fault). In the light emitting device disclosed in JP2009-032966, the carrier concentration is increased and carrier recombination is promoted by introducing a stacking fault into a thin-film layer having a nonpolar surface as a principal plane of growth. On the other hand, in the photoelectric conversion device according to the present invention, the stacking fault is introduced into the photoelectric conversion (semiconductor) grains in the photoelectric conversion device so as to suppress recombination of a very small amount of carriers contained in the photoelectric conversion grains. Therefore, the photoelectric conversion device according to the present invention is completely different from the light emitting diode disclosed in JP2009-032966.

### BRIEF DESCRIPTION OF THE DRAWINGS

FIG. 1 is a schematic cross-sectional view illustrating a cross section of a photoelectric conversion device according to an embodiment of the present invention.
FIG. 2 is a diagram indicating the relationships between the lattice constant and the bandgap in I-III-VI semiconductor compounds.
FIGS. 3A, 3B, 3C, and 3D are cross-sectional views of the structures in respective stages in a process of producing the photoelectric conversion device of FIG. 1.
FIG. 4 shows an SEM (scanning electron microscope) image of CIS grains produced in a concrete example 5 and a TEM (transmission electron microscope) image of a section of one of the CIS grains observed in the SEM image.

### DESCRIPTION OF PREFERRED EMBODIMENTS

The photoelectric conversion device as an embodiment of the present invention and concrete examples of the embodiment are explained below with reference to the accompanying drawings, in which the dimensions of the illustrated elements are differentiated from the dimensions of the elements of the actual photoelectric conversion devices for clarification.

### 1. Photoelectric Conversion Device

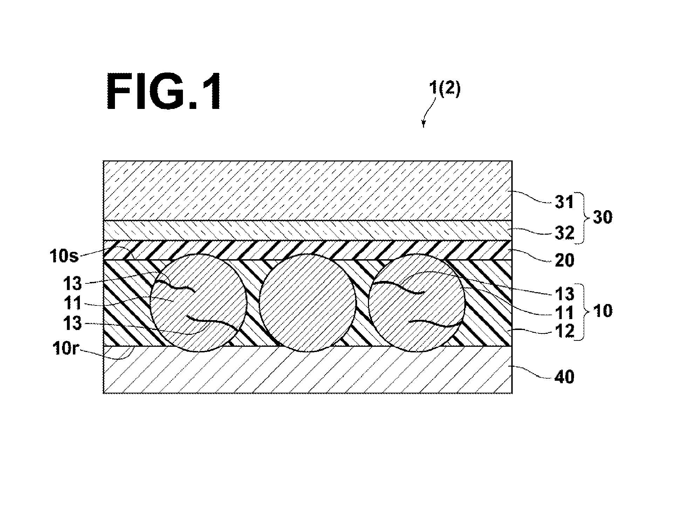

FIG. 1 is a schematic cross-sectional view illustrating a cross section, along a thickness direction, of a photoelectric conversion device according to the embodiment of the present invention.

As illustrated in FIG. 1, the photoelectric conversion device 1 comprises a photoelectric conversion (semiconductor) layer 10 and first and second electrodes 30 and 40. The first electrode 30 is formed in contact with a front surface 10s of the photoelectric conversion layer 10 (through a buffer layer 20). The front surface 10s functions as a light absorption surface. The second electrode 40 is formed in contact with a rear surface 10r of the photoelectric conversion layer 10. The photoelectric conversion layer 10 is a monograin film in which each of separate semiconductor grains 11 having a photoelectric conversion property is partially buried in a binder layer 12.

The semiconductor grains 11 have an average diameter in the range from 1 micrometer to 60 micrometers. Each of at least part of the semiconductor grains 11 contains at least one stacking fault 13. The semiconductor grains 11 are in contact with the second electrode 40 at the rear surface 10r, and in contact with the first electrode 30 at the front surface 10s through the buffer layer 20.

The first and second electrodes 30 and 40 are formed of an electrically conductive material, and the first electrode 30, which is arranged on the light-incident side of the photoelectric conversion layer 10, is optically transparent.

The main component of the second electrode 40 is not specifically limited, and is preferablymetal because of the superior conductivity of the metal. For example, the main component of the second electrode 40 is preferably one or a combination of Mo, Cr, and W, and is particularly preferably Mo . The thickness of the second electrode 40 is not specifically limited, and is preferably 0.3 to 1.0 micrometers.

The main component of the first electrode 30 is not specifically limited, and is preferably one or a combination of ZnO, ITO (indium tin oxide), and SnO₂ because ZnO, ITO, and SnO₂ exhibit high optical transparency and low electrical resistance. In addition, the first electrode 30 is doped with a dopant for realizing a predetermined conductivity type. The dopant is, for example, Ga, Al., or B. The thickness of the first electrode 30 is not specifically limited, and is preferably 0.6 to 1.0 micrometers.

Each of the first and second electrodes 30 and 40 may have either a single-layer structure or a multilayer structure such as a two-layer structure. Preferably, the first electrode 30 has a two-layer structure of an i layer 32 and an n layer 31. The i layer 32 is formed of an i-type material on the side nearer to the buffer layer 20, and the n layer 31 is formed of an n-type material on the side farther from the buffer layer 20. Alternatively, the n layer 31 may be substituted with a layer of a p-type material.

The manner of forming each of the first and second electrodes 30 and 40 is not specifically limited, and is, for example, a vapor phase technique such as electron beam evaporation or sputtering.

The main component of the buffer layer 20 is not specifically limited, and is preferably one or a combination of CdS, ZnS, ZnO, ZnMgO, and ZnS(O, OH). As disclosed in, for example, Japanese Unexamined Patent Publication No. 2002-343987, it is possible to form between the buffer layer 20 and the photoelectric conversion layer 10 a junction interface at which carrier recombination does not occur.

The thickness of the buffer layer 20 is not specifically limited, and is preferably 0.03 to 0.1 micrometers.

Although the buffer layer 20 is formed over the photoelectric conversion layer 10 in the example of FIG. 1, alternatively, the buffer layer 20 may be formed to cover each of the separate semiconductor grains 11 other than the part of each semiconductor grain which is in contact with the second electrode 40.

An example of a preferable combination of the photoelectric conversion device 1 is the first electrode 30 of Mo, the buffer layer 20 of CdS, the photoelectric conversion layer 10 of CIGS, and the second electrode 40 of ZnO.

The conductivity types of the photoelectric conversion layer 10, the buffer layer 20, the first electrode 30, and the second electrode 40 are not specifically limited. Normally, the photoelectric conversion layer 10 is formed of a p-type, the second electrode 40 is formed of an n-type (e.g., n-CdS), and the first electrode 30 is formed of an n-type (e.g., n-ZnO) or in a multilayer structure of an i layer and an n layer (e.g., a lamination of i-ZnO layers and n-ZnO layers). In such a structure, a p-n junction or a p-i-n junction is realized between the photoelectric conversion layer 10 and the first electrode 30.

The binder layer 12 is not specifically limited, and is preferably an organic binder such as polyethylene, polypropylene, polystyrene, and polyester. The thickness of the binder layer 12 is not specifically limited as long as stable fixation of the semiconductor grains 11 and satisfactory contact between the semiconductor grains 11 and the buffer layer 20 and between the semiconductor grains 11 and the second electrode 40 can be realized.

Although the semiconductor grains 11 are not specifically limited, the main component is preferably realized by at least one semiconductor compound having a chalcopyrite structure. The at least one semiconductor compound having a chalcopyrite structure is preferably a Group I-III-VI semiconductor, which is composed of at least one Group Ib element, at least one Group IIIb element, and at least one Group VIb element. From the viewpoint of realization of high optical absorptance and high energy conversion efficiency, further preferably, the at least one Group Ib element is at least one of copper (Cu) and silver (Ag), the at least one Group IIIb element is at least one of aluminum (Al), gallium (Ga), and indium (In), and the at least one Group VIb element is at least one of sulfur (S), selenium (Se), and tellurium (Te). Hereinafter, the I-III-VI semiconductor compound having the further preferable composition as above is referred to as the further preferable I-III-VI semiconductor compound. The following are examples of the further preferable I-III-VI semiconductor compound.

CuAlS₂, 0CuGaS₂, CuInS₂, CuAlSe₂, CuGaSe₂, CuInSe₂ (CIS) , AgAlS₂, AgGaS₂, AgInS₂, AgAlSe₂,'AgGaSe₂₁ AgInSe₂, AgAlTe₂, AgGaTe₂, AgInTe₂, Cu (In₁₋ₓGaₓ) Se₂ (CIGS), Cu (In₁₋ₓAlₓ) Se₂, Cu (In₁₋ₓGaₓ) (S, Se)₂, Ag(In₁₋ₓGax)_{Se2}, _{A}g(In₁₋ₓGaₓ) (S, Se)₂

Particularly preferably, the photoelectric conversion layer 30 contains at least one of CuInS₂, CuInSe₂ (CIS), Cu (In, Ga) S₂, Cu (In, Ga)Se₂ (CIGS) , CuIn (S, Se)₂, and Cu (Tn, Ga) (S, Su)₂ - Cu(In, Ga) S₂, Cu (In, Ga) Se₂ (CIGS) are respectively solid solutions of Ga and CuInS₂, CuInSe₂ (CIS). CIS and CIGS are reported to exhibit high optical absorptance and high energy conversion efficiency. Further, the degrees of deterioration of CIS and CIGS caused by irradiation with light are relatively small, and CIS and CIGS have high durability.

In the case where the semiconductor grains 11 are CIGS grains, the Ga concentration and the Cu concentration in the semiconductor grains 11 are not specifically limited. The molar ratio of the Ga content to the total content of the Group III elements in the semiconductor grains 11 is preferably 0.05 to 0.6, and more preferably 0.2 to 0.5. The molar ratio of the Cu content to the total content of the Group III elements in the semiconductor grains 11 is preferably 0.7 to 1.0, and more preferably 0.8 to 0.98.

The semiconductor grains 11 contain impurities for realizing the desired conductivity type. The semiconductor grains 11 can be doped with such impurities by diffusion from an adjacent layer and/or by another active doping process.

The semiconductor grains 11 may contain one or more semiconductor materials other than the Group I-III-VI semiconductor. For example, the one or more semiconductor materials other than the Group I-III-VI semiconductor may be a semiconductor material which is composed of one or more Group IVb elements such as silicon (i.e., a Group IVb semiconductor), a semiconductor material which is composed of one or more Group IIIB elements and one or more Group Vb elements such as GaAs (i.e., a Group III-V semiconductor), or a semiconductor material which is composed of one or more Group IIb elements and one or more Group VIb elements such as CdTe (i.e., a Group II-VI semiconductor).

As long as the characteristics of the semiconductor grains 11 are not substantially affected, the semiconductor grains 11 may contain an arbitrary component in addition to the impurities for realizing the desired conductivity type of the semiconductor.

The semiconductor grains 11 may include only grains having an identical composition, or may include a plurality of types of grains respectively having different compositions.

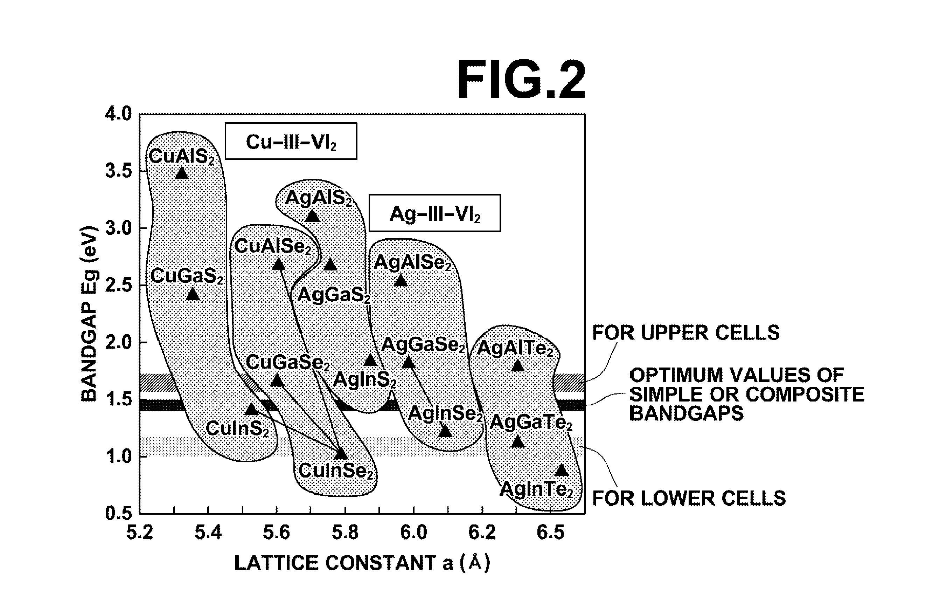

FIG. 2 is a diagram indicating the relationships between the lattice constant and the bandgap in representative Group I-III-VI semiconductor compounds. As understood from FIG. 2, it is possible to realize various bandgaps by controlling the composition of the Group I-III-VI semiconductor compound. Therefore, it is possible to realize a desired bandgap in the semiconductor grains 11 by appropriately determining the composition of the Groups Ib, IIIB, and VIb element. Preferably, in the aforementioned further preferable I-III-VI semiconductor compound composed of the at least one Group Ib element such as Cu and Ag, the at least one Group IIIb element such as Al, Ga, and In, and the at least one Group VIb element such as S, Se, and Te, it is possible to realize the desired bandgap in the semiconductor grains 11 by changing the concentration of at least one of the elements Cu, Ag, Al, Ga, In, S, Se, and Te, and preferably by changing the concentration of at least one of Ag, Ga, Al, and S. For example, in the case where the semiconductor grains 11 are CIGS grains, the bandgap can be adjusted in the rage of 1.04 to 1.68 eV.

At least part of the semiconductor grains 11 contain a stacking fault 13. Since the stacking fault 13 suppresses carrier recombination, the photoelectric conversion efficiency of each semiconductor grain containing the stacking fault 13 is increased. Therefore, it is more preferable that the number of semiconductor grains each containing one or more stacking faults is greater.

In addition, the number of stacking faults in each semiconductor grain may be one, and is preferably approximately two to eight. Although a greater number of stacking faults more effectively suppress the carrier recombination, an excessive number of stacking faults reduces the carrier mobility, and makes the semiconductor grains fragile, so that the resistance is increased and the photoelectric conversion device becomes difficult to handle.

Although the manner of producing the semiconductor grains is not specifically limited as long as stacking faults can be contained in the semiconductor grains, the present inventor has found the following process, which is simple and enables production of semiconductor grains each containing one or more stacking faults. First, a mixture of components containing the constituent elements of the semiconductor grains 11 or salts of the constituent elements is prepared. It is preferable that the compositions of the respective components in the mixture be prepared so as to realize the stoichiometric composition of the semiconductor grains 11. For example, in the case where the semiconductor grains 11 are made of a I-III-VI semiconductor compound, it is possible to mix powders of the simple substances of the respective elements, or powders of one or more I-VI semiconductors and one or more III-VI semiconductors. Further, powders of one or more metal alloys may be mixed.

Subsequently, a flux such as potassium iodide is added to the above mixture, and then the mixture is further mixed. Thereafter, the mixture is baked by heating the mixture above a reaction temperature under a nonoxidation atmosphere at atmospheric pressure so as to cause a reaction in the mixture. Preferably, the amount of the added flux is 40 volume percent or more with respect to the volume of the mixture before the addition of the flux.

After the baking, the flux is washed off with water, and a small amount of material which is unreacted and adheres to the surfaces of the semiconductor grains produced by the reaction is removed with a KCN water solution or the like. Then, the semiconductor grains are sufficiently dried. Thus, the semiconductor grains 11 containing stacking faults are obtained.

However, in the case where the mixture contains one or more simple substances of metals, as the one or more simple substances of metals fuse, the reaction proceeds so as to precipitate the semiconductor grains having the desired composition. Therefore, heating of the mixture should be performed under such a temperature condition that the mixture melts and semiconductor grains precipitate out of the molten mixture (as explained later in the concrete example 1).

In the case where the mixture is constituted by semiconductor powders, the reaction is a solid-phase reaction. The solid-phase reaction is preferable because stacking faults can be more easily produced in semiconductor grains when the semiconductor grains are produced by the solid-phase reaction (as explained later in the concrete examples) . As indicated in the concrete examples 2 to 5, the stacking faults can be produced in a greater number of semiconductor grains when the amount of the added flux is increased.

In the present embodiment, the average diameter of the semiconductor grains 11 is 1 to 60 micrometers, and the coefficient of variation of the diameters of the semiconductor grains 11 is preferably less than 30%. Since the photoelectric conversion layer 10 is monograin film, basically only one semiconductor grain exists along the thickness direction of the photoelectric conversion layer 10 as illustrated in FIG. 1. Therefore, the lower limit of the average diameter of the semiconductor grains 11 is the minimum value which enables formation of a monograin film, and it is possible to consider that a monograin film can be formed when the average diameter of the semiconductor grains 11 is at least 1 micrometer. In addition, the upper limit of the average diameter of the semiconductor grains 11 is obtained in consideration of the fact that excessively large diameters of the semiconductor grains 11 unnecessarily increase the series resistance in the photovoltaic system.

Since the photoelectric conversion layer 10 is a monograin film, increase in the variations in the diameters of the semiconductor grains 11 decreases the surface evenness, and increases the variations in the inter-electrode distance in the photoelectric conversion device, so that stable output of a desired voltage is impeded. Therefore, it is more preferable that the coefficient of variation in the diameters of the semiconductor grains 11 be smaller. In addition, decrease in the coefficient of variation in the diameters of the semiconductor grains 11 improves electrical contact between the semiconductor grains 11 and the electrodes. Therefore, when the coefficient of variation in the diameters of the semiconductor grains 11 is decreased, it is possible to consider that recombination of an electron and a hole becomes less likely to occur in the photoelectric conversion layer 10, and loss such as heat generation decreases, so that photoelectric conversion efficiency increases.

The present inventor and colleagues of the present inventor have found that the photoelectric conversion efficiency and the durability of the photoelectric conversion device having a photoelectric conversion layer realized by a monograin film are greatly affected by the evenness of the interfaces between the photoelectric conversion layer and the electrodes when the photoelectric conversion device is used in a solar cell. Therefore, the photoelectric conversion efficiency and the durability of the photoelectric conversion device having a photoelectric conversion layer realized by a monograin film are greatly improved when the coefficient of variation of the diameters of the semiconductor grains 11 is less than 30%.

The present inventor and colleagues of the present inventor consider that in the photoelectric conversion device having a photoelectric conversion layer realized by a monograin film with a great coefficient of variation in the diameters of the semiconductor grains, relatively small semiconductor grains (which are not in contact with the electrodes above and under the photoelectric conversion layer) do not contribute photoelectric conversion, and the photoelectric conversion efficiency is likely to decrease because of volatilization of the constituent elements (such as the chalcogens) from relatively large semiconductor grains. In addition, the present inventor and colleagues of the present inventor also consider that the great coefficient of variation in the diameters of the semiconductor grains further promotes degradation of the photoelectric conversion device (e.g., curvature of the electrode surfaces) since it is difficult to maintain the flatness of the interfaces between the photoelectric conversion layer and the electrodes. However, it is possible to expect that in the photoelectric conversion devices in which the coefficient of variation in the diameters of the semiconductor grains is smaller than 30%, the decrease in the photoelectric conversion efficiency and the degradation of the photoelectric conversion devices which are caused by the variations in the diameters of the semiconductor grains are significantly reduced, and the durability of the photoelectric conversion devices is significantly improved.

### 2. Production Process

Hereinbelow, a process for producing the photoelectric conversion device 1 is explained.

First, the separate semiconductor grains which have a photoelectric conversion property and are substantially separate and at least part of which each contain the stacking fault 13 are produced by the aforementioned process. Then, the semiconductor grains 11 having a coefficient of variation less than 30% are sifted out from the semiconductor grains produced by the aforementioned process.

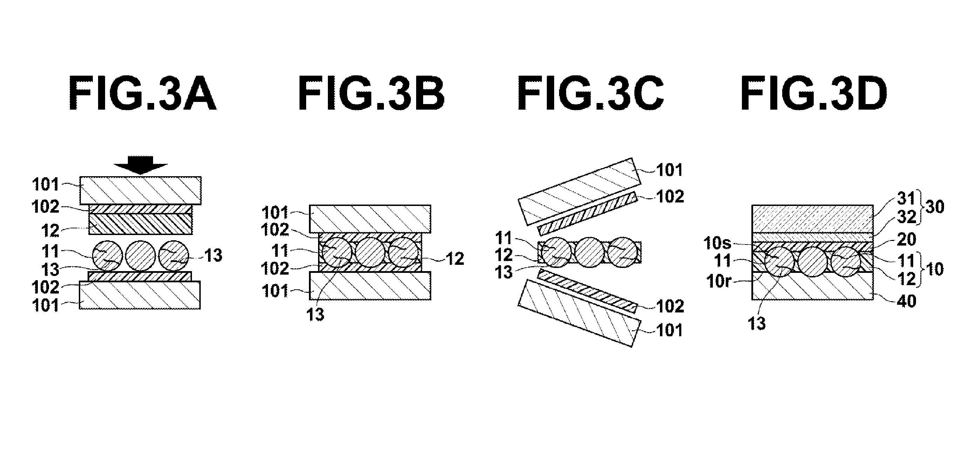

Thereafter, the photoelectric conversion device 1 is produced by using the semiconductor grains 11 obtained as above. FIGS. 3A, 3B, 3C, and 3D are cross-sectional views of the structures in respective stages in a preferable process for producing the photoelectric conversion device of FIG. 1.

First, as illustrated in FIG. 3A, a pair of (first and second) metal plates 101 are prepared, a first Gel-Pak® sheet 102 containing an adhesive elastic gel-like polymer layer is arranged on the first metal plate 101, and the semiconductor grains 11 are arranged on the Gel-Pak sheet 102 in such a manner as to form a monograin layer. (Specifically, the first Gel-Pak sheet 102 and the second Gel-Pak sheet 102 explained below are GEL-FILM™ WF-40/1.5-X4, manufactured by Gel-Pak, a division of Delphon Industries, LLC.)

On the other hand, the second Gel-Pak sheet 102, which is similar to the first Gel-Pak sheet 102, is held on the second metal plate 101, and a polypropylene film (binder layer) 12 having an appropriate thickness is held on the second Gel-Pak sheet 102. (The appropriate thickness of the polypropylene film 12 is explained before.) Then, the above layers of the second metal plate 101, the second Gel-Pak sheet 102 and the polypropylene film 12 are placed over the layers of the first metal plate 101, the first Gel-Pak sheet 102, and the semiconductor grains 11 so that the polypropylene film 12 covers the semiconductor grains 11. Subsequently, pressure is applied from the back surface of the first metal plate 101 to the layers of the first metal plate 101, the first Gel-Pak sheet 102, the semiconductor grains 11, the binder layer 12, the second Gel-Pak sheet 102, and the secondmetal plates 101, and the pressurized layers are heated above the melting temperature of the polypropylene film 12. After the polypropylene film 12 is sufficiently melted, the pressurized layers are cooled. The pressure applied to the above layers is such that sufficient contact is achieved between the tops of the semiconductor grains 11 and the second Gel-Pak sheet 102 and no excessive pressure is imposed on the semiconductor grains 11. (For example, the above layers are heated at 200°C for several minutes while the pressure of 180 g/cm² is applied to the layers along the thickness direction, and thereafter the pressurized layers are cooled by natural heat dissipation.) Thus, the layered structure as illustrated in FIG. 3B is obtained.

Thereafter, the first and second metal plates 101 and the first and second Gel-Pak sheets 102 are peeled off, so as to obtain a photoelectric conversion layer 10 in which the tops and the bottoms of the semiconductor grains 11 are exposed as illustrated in FIG. 3C. According to the process in the present embodiment, the tops and the bottoms of a sufficient number of separate semiconductor grains can be easily exposed to the electrode surfaces.

Finally, the second electrode 40 is formed on the rear surface 10r of the photoelectric conversion layer 10, and then the buffer layer 20 and the first electrode 30 are formed in this order on the front surface 10s. Thus, the photoelectric conversion device 1 as illustrated in FIG. 3D is obtained.

The photoelectric conversion device 1 can be preferably used in a solar cell 2. Although not shown, a solar cell can be produced by attaching a cover glass, a protection film, and the like to the photoelectric conversion device 1 and arranging wirings as appropriate.

The electrodes and the wirings may be formed, for example, by patterning using lithography or the like after film formation by CVD, sputtering, or the like.

### 3. Advantages

The photoelectric conversion device comprising a monograin film of semiconductor grains which have a photoelectric conversion property and at least part of which contain one or more stacking faults exhibits photoelectric conversion efficiency which is considerably higher than the photoelectric conversion efficiency of the photoelectric conversion device comprising a monograin film of semiconductor grains which have a photoelectric conversion property and contain no intentionally introduced stacking fault. As indicated in Table 1 for the concrete examples, the photoelectric conversion efficiency in some concrete examples exceeds 11%.

As explained above, the photoelectric conversion layer 10 constituting the photoelectric conversion device 1 (or the solar cell 2) is a monograin film in which each of separate semiconductor grains 11 having a photoelectric conversion property is partially buried, the semiconductor grains 11 have an average diameter in the range from 1 micrometer to 60 micrometers, and each of at least part of the semiconductor grains 11 contain at least one stacking fault. In the photoelectric conversion device 1 having the above structure, the stacking fault suppresses carrier recombination in the semiconductor grains 11, so that the carrier lifetime can be increased. Therefore, according to the present invention, the photoelectric conversion device 1 exhibit satisfactory photoelectric conversion efficiency.

The present invention is not limited to the embodiment and the variations explained above, and the structures of the embodiment and the variations may be further modified within the scope of the present invention when necessary.

### 4. Concrete Example

The present inventor has produced concrete examples of the photoelectric conversion device according to the present invention and a comparison example as indicated below.

### 4.1 Concrete Example 1

First, a CuIn (1:1) alloy and a Se powder have been mixed in the molar ratio of 1:2, and further an amount of a flux of KI corresponding to 40 volume percent of the volume of the above mixture of the CuIn alloy and the Se powder has been mixed with the mixture of the CuIn alloy and the Se powder. Then, the mixture with the KI flux has been put in a crucible of alumina, and baked by heating the mixture at 530°C in an Ar atmosphere for 20 hours. After the baking, KI has been washed off with pure water, and a small amount of CuSe adhered to the surfaces of the semiconductor grains obtained by the baking has been removed with a 10% water solution of KCN. Thereafter, the semiconductor grains have been dried, and sifted by using a sieve with openings of 55 micrometers and a sieve with openings of 40 micrometers. Thus, CIS grains having an average diameter of 49 micrometers (and the grain sizes in the range from 40 to 55 micrometers) have been obtained. The average diameter and the coefficient of variation have been measured by using the granularity distribution analyzer LA-920, which utilizes diffraction and scattering of laser for measurement of granularity and manufactured by Horiba, Ltd.

Subsequently, a pair of (first and second) metal plates (specifically, a pair of sheets of aluminum foil each having the thickness of 80 micrometers) have been prepared, and a monograin film has been formed on the first metal plate by regularly arranging depressions in the first metal plate and placing CIS grains in the depressions. On the other hand, an elastic Gel-Pak® sheet (GEL-FILM™ WF-40/1.5-X4, manufactured by Gel-Pak, a division of Delphon Industries, LLC) and a polypropylene film (TRANSPROP™ OL, manufactured by Transilwrap Company, Inc.) have been held on the second metal plate in this order, and then the above layers of the second metal plate, the second Gel-Pak sheet and the polypropylene film have been placed over the CIS grains arranged on the first metal plate so that the polypropylene film covers the CIS grains. The layers from the first metal plates to the second metal plate have been heated at 200°C for five minutes while the pressure of 180 g/cm² is applied to the layers along the thickness direction, and thereafter the pressurized layers have been cooled by natural heat dissipation.

Thereafter, the first and second metal plates and the Gel-Pak sheets have been peeled off, so as to obtain a photoelectric conversion layer in which the tops and the bottoms of the CIS grains are exposed.

Finally, a metal film of Mo having the thickness of 0.8 micrometers has been formed over a surface of the photoelectric conversion layer by sputtering, and then a buffer layer of CdS having the thickness of 50 nanometers, an i-ZnO layer having the thickness of 80 nanometers, and a ZnO:Al layer having the thickness of 500 nanometers have been formed in this order on the opposite surface of the photoelectric conversion layer by sputtering. Thus, the photoelectric conversion device as the concrete example 1 has been obtained.

### 4.2 Concrete Example 2

First, a Cu₂Se powder and an Tn₂Se₃ powder have been mixed in the molar ratio of 1:1, and then an amount of a flux of KI corresponding to 40 volume percent of the total volume of the above mixture of the Cu₂Se powder and the In₂Se₃ powder has been mixed with the mixture of the Cu₂Se powder and the In₂Se₃ powder. Subsequently, an amount of Se powder corresponding to five times the molar equivalent of the Cu₂Se power has been mixed with the above mixture with the KI flux. The photoelectric conversion device as the concrete example 2 has been produced in a similar manner to the concrete example 1 except that the above mixture of the Cu₂Se powder and the In₂Se₃ powder has been used for producing the CIS grains. The CIS grains have an average diameter of 49 micrometers (and the grain sizes in the range from 40 to 55 micrometers).

### 4.3 Concrete Examples 3, 4, and 5

The photoelectric conversion devices as the concrete examples 3, 4, and 5 have been produced in a similar manner to the concrete example 2 except that the added amount of the KI flux in each of the concrete examples 3, 4, and 5 is different from the concrete example 2.

### 4.4 Concrete Example 6

The photoelectric conversion device as the concrete example 6 has been produced in a similar manner to the concrete example 4 except that Cu₂S, instead of Cu₂Se, has been used for production of CIS grains.

### 4.5 Comparison Example

The photoelectric conversion device as the comparison example has been produced in a similar manner to the concrete example 1 except that the CIS grains have been produced by encapsulating the mixture in a vacuum quartz ampule instead of the alumina crucible, and heating the ampule while freely moving and rotating the ampule.

### 4.6 Evaluation

The photoelectric conversion efficiency of the photoelectric conversion devices as the concrete examples 1 to 6 and the comparison example has been measured by using AM (air mass) 1.5 simulated sunlight with the intensity of 100 mW/cm². In addition, the number of semiconductor grains each containing at least one stacking fault in the photoelectric conversion layer in each photoelectric conversion device has been counted in the manner described in

### "SUMMARY OF THE INVENTION."

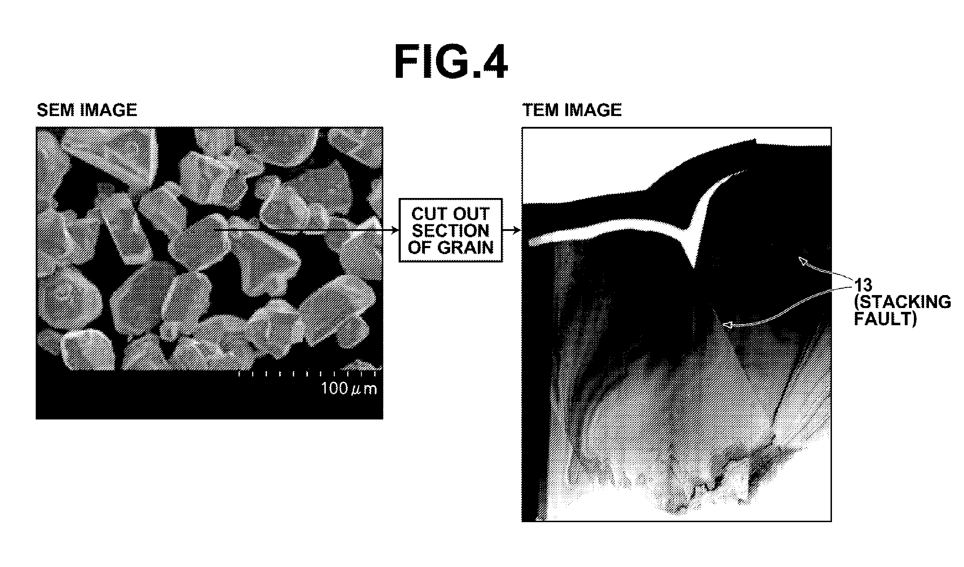

FIG. 4 shows an SEM (scanning electron microscope) image of the CIS grains produced in the concrete example 5 and a TEM (transmission electron microscope) image of a section of one of the CIS grains observed in the SEM image. In addition, the mixture used for producing the CIS grains, the amount of KI added to the mixture, the vessel used in the baking of the mixture, the proportion of semiconductor grains containing at least one stacking fault, and the photoelectric conversion efficiency of the photoelectric conversion device in each of the concrete examples 1 to 6 and the comparison example are summarized in Table 1. The data in Table 1 indicate that the photoelectric conversion efficiency increases with the proportion of semiconductor grains containing at least one stacking fault. That is, the advantage of the present invention has been confirmed. It have been confirmed that the photoelectric conversion device according to the present invention exhibits high photoelectric conversion efficiency.

**Table 1**

| | Starting Material | Added Amount of KI (volume %) | Vessel Used in Baking | Proportion (%) of Grains Containing Stack Fault | Conversion Efficiency (%) |
|---|---|---|---|---|---|
| Concrete | CuIn + Se | 40 | Alumina | 6 | 7.9 |
| Example 1 | | | Crucible | | |
| Concrete | Cu₂Se + | 40 | Alumina | 11 | 9.0 |
| Example 2 | In₂Se₃ | | Crucible | | |
| Concrete | Cu₂Se + | 100 | Alumina | 42 | 9.8 |
| Example 3 | In₂Se₃ | | Crucible | | |
| Concrete | Cu₂Se + | 150 | Alumina | 69 | 10.7 |
| Example 4 | In₂Se₃ | | Crucible | | |
| Concrete | Cu₂Se + | 200 | Alumina | 90 | 11.2 |
| Example 5 | In₂Se₃ | | Crucible | | |
| Concrete | Cu₂S + | 200 | Alumina | 90 | 11.5 |
| Example 6 | In₂Se₃ | | Crucible | | |
| Comparison | CuIn + Se | 40 | Quartz | 0 | 5.7 |
| Example | | | Ampule | | |

### 5. Industrial Usability

The photoelectric conversion device according to the present invention can be preferably used in solar cells, infrared sensors, and the like.

## Claims

1. A photoelectric conversion device (1) comprising:
a photoelectric conversion layer (10) containing a semiconductor and having a first surface (10s) as a light absorption surface and a second surface (10r) opposite to the first surface (10s);
a first electrode (30) formed substantially in contact with said first surface (10s); and
a second electrode (40) formed substantially in contact with said second surface (10r);
**characterized in that**
said photoelectric conversion layer (10) is a monograin film of semiconductor grains (11) which are monograin film of separate semiconductor grains which are arranged substantially in a single layer and each of which is at least partially buried in a binder layer (12), the semiconductor grains (11) have a photoelectric conversion property and an average diameter in a range from one micrometer to 60 micrometers, and each of at least part of the semiconductor grains (11) contains at least one stacking fault (13) .

2. A photoelectric conversion device (1) according to claim 1, wherein at least 5% of said semiconductor grains (11) contain at least one stacking fault (13).

3. A photoelectric conversion device (1) according to claim 2, wherein at least 10% of said semiconductor grains (11) contain at least one stacking fault (13).

4. A photoelectric conversion device (1) according to claim 3, wherein at least 40% of said semiconductor grains (11) contain at least one stacking fault (13).

5. Aphotoelectric conversion device (1) according to either of claims 1 to 4, wherein said semiconductor grains (11) contain as a main component at least one semiconductor compound having a chalcopyrite structure.

6. A photoelectric conversion device (1) according to claim 5, wherein said semiconductor grains (11) contain as at least one main component at least one semiconductor compound composed of at least one Group Ib element, at least one Group IIIb element, and at least one Group VIb element.

7. A photoelectric conversion device (1) according to claim 6, wherein said at least one Group Ib element is at least one of copper and silver, said at least one Group IIIb element is at least one of aluminum, gallium, and indium, and said at least one Group VIb element is at least one of sulfur, selenium, and tellurium.

8. A solar cell (2) **characterized in** comprising said photoelectric conversion device (1) according to either of claims 1 to 7.
